# EUROPEAN PATENT SPECIFICATION

(11) **EP 4 502 581 B1**
(45) Date of publication and mention of the grant of the patent: **09.09.2026**
(21) Application number: 23188591.4
(22) Date of filing: 31.07.2023
(51) Int. Cl.: G01N 24/10, G01R 33/26, G01R 33/32

(54) **SPIN DEFECT SENSOR DEVICE**
SPINDEFEKT-SENSORVORRICHTUNG
DISPOSITIF DE DÉTECTION UTILISANT UN DÉFAUT DE SPIN

(43) Date of publication of application: 05.02.2025
(73) Proprietor: QZabre AG, 8050 Zürich (CH)
(72) Inventor: Puebla Hellmann, Gabriel, 8050 Zürich (CH)
(74) Representative: Betten & Resch

(56) References cited:
- CN-A- 104 360 152
- CN-A- 111 198 344
- CN-A- 116 299 085
- CN-A- 116 299 098
- DE-A1- 102021 127 374
- US-B2- 11 293 940
- NILS KOLJA WESSLING ET AL: "Fabrication and transfer print based integration of free-standing GaN membrane micro-lenses onto semiconductor chips", ARXIV.ORG, CORNELL UNIVERSITY LIBRARY, 201 OLIN LIBRARY CORNELL UNIVERSITY ITHACA, NY 14853, 10 August 2022 (2022-08-10), XP091291776
- DUAN D. ET AL: "Efficient nitrogen-vacancy centers' fluorescence excitation and collection from micrometer-sized diamond by a tapered optical fiber in endoscope-type configuration", OPTICS EXPRESS, vol. 27, no. 5, 22 February 2019 (2019-02-22), US, pages 6734, XP093116245, ISSN: 1094-4087, DOI: 10.1364/OE.27.006734
- DMITRIEV A L ET AL: "Concept of a microscale vector magnetic field sensor based on nitrogen-vacancy centers in diamond", JOURNAL OF THE OPTICAL SOCIETY OF AMERICA B,, vol. 33, no. 3, 17 November 2015 (2015-11-17), XP002773654

## Description

### TECHNICAL FIELD

The present disclosure relates to a spin defect sensor device comprising a diamond having at least one spin defect. Spin defect sensor devices have numerous applications, comprising e.g. magnetic and electric field sensing, magnetic noise measurements, temperature measurements, fluorescence resonance energy transfer (FRET), NMR sensing, radical sensing via relaxometry, single-photon spectroscopy, quantum information processing and bioimaging.

### BACKGROUND

A key issue for spin defect sensors is fluorescence extraction, which generally is challenging due to the high refractive index of diamond and the high refractive index mismatch between diamond and free space and/or diamond and a corresponding waveguide.

Several ways of extracting fluorescence from spin defects are known.

Some devices use nanocrystals that are integrated in waveguides. However, there is no shape control and the coherence of the nanocrystals can be poor. In addition, there is no control over the orientation of nanocrystals with respect to the waveguides, which may be detrimental for signal reconstruction, e.g. due to the unknown orientation of the spin defect.

It is also known to use nanocrystals arranged on waveguides. However, the coupling efficiency between those waveguides and the respective nanocrystals can be a problem. Also here, there is no control over the nanocrystal orientation with respect to the waveguides.

Maletinsky et al., "A robust scanning quantum system for nanoscale sensing and imaging", doi: 10.48550/arXiv.1108.4437, discloses using a single-crystalline diamond nanopillar probe containing a single Nitrogen-Vacancy (NV) color center. The diamond nanopillar is used as a photon waveguide for collimating NV emissions. Disadvantages of using diamond nanopillars are that such devices are difficult to scale, that diamonds are expensive and that fabrication is challenging. Diamond nanopillars also do not offer the possibility to include integrated optics/electronics. In addition, background fluorescence of the diamond decreases the signal.

It is also known to use diamonds arranged on an end of a waveguide, e.g. an optical fiber. However, usually the diamond is not shaped to act together with the waveguide. Dmitirev and Vershovskii, "Concept of a microscale vector magnetic field sensor based on nitrogen-vacancy centers in diamond", doi: 10.1364/JOSAB.33.0000B1, disclose a diamond crystal attached to an end of an optical fiber by using an optically transparent glue.

CN 116 299 085 A discloses a magnetometer probe comprising a magnetometer probe body, wherein the magnetometer probe body comprises a multimode optical fiber, one end of the multimode optical fiber is provided with a conical lens, and the end part of the conical lens is provided with a diamond head.

It is an object of the present disclosure to provide a spin defect sensor that exhibits good fluorescence extraction and addresses the aforementioned challenges.

### SUMMARY

The present invention is defined by the independent claims. Dependent claims specify embodiments thereof.

According to a first aspect of the present disclosure a sensor device is provided comprising a tip portion comprising a coupling element and a diamond element, e.g. a single crystal diamond element, bonded to the coupling element. The sensor device further comprises a dielectric light-transmissive element, a receiver element, a microwave antenna, and an excitation light source. The diamond element comprises at least one spin defect configured to emit an optical signal. The coupling element configured to couple the optical signal into the dielectric light-transmissive element is formed of a material different from diamond and is formed integrally with the dielectric light-transmissive element. The dielectric light-transmissive element is configured to couple the optical signal into the receiver element. The coupling element protrudes from the dielectric light-transmissive element. The microwave antenna is configured to couple a microwave field to the spin defect. The excitation light source is configured to optically excite the spin defect by outputting excitation light.

The tip portion may be configured to be scanned over a sample surface. The coupling element may protrude from the dielectric light-transmissive element towards the sample surface.

Conventionally, diamonds may be used that directly couple an optical signal emitted by a spin defect into an optical fiber or into free space. An aspect of the present disclosure may be understood as splitting a conventionally used diamond into the diamond element and the coupling element according to the present disclosure, wherein the diamond element comprises a spin defect and couples an optical signal emitted by the spin defect into the coupling element, which in turn couples the optical signal, received from the diamond element, into the dielectric light-transmissive element.

A combination of the diamond element and a corresponding coupling element may provide additional leeway in shaping the diamond element and the coupling element as compared to a conventionally used diamond. E.g., the coupling efficiency of the diamond element to the dielectric light-transmissive element may be increased, e.g. by dimensioning the diamond element for improved/optimal outcoupling. The present disclosure also allows the diamond element to have a cavity function. The present disclosure also allows implementation of integrated devices, e.g. integrated photonic devices, e.g. integrated photonic amplifiers.

Materials of the coupling element and the diamond element may be different. The coupling element may comprise a material that is not comprised in the diamond element. Using a coupling element material that is different from diamond may allow for easier processing of the coupling element material as compared to diamond. E.g., a shape of the coupling element may be created easier due to easier processability and/or the use of standard materials and standard processes for the coupling element.

The present disclosure may allow to reduce the amount of diamond material required, thus reducing costs.

The present disclosure may allow easier fabrication as the diamond thickness can be substantially reduced. Using a thin diamond may lead to more homogeneous resist films improving reproducibility and accuracy of lithographic processes.

The present disclosure may allow to reduce the thickness of the diamond element. This may also reduce the effect of aberrations in diamond. Reducing the thickness may improve the coupling efficiency between the diamond element and the dielectric light-transmissive element. Reducing the thickness may also reduce the amount of background fluorescence of the diamond, which may have a detrimental effect on the optical signal of the spin defect, e.g. increasing noise on the optical signal.

The present disclosure may also allow to use integrated photonics, e.g. optical amplifiers, e.g. in the coupling element and/or in the dielectric light-transmissive element. This may in turn improve the quality of optical signals of the spin defect received by the receiver element.

The diamond element may be a single crystal diamond element.

The dielectric light-transmissive element may be light-transmissive at least at a wavelength of the optical signal emitted by the spin defect. Being light-transmissive may refer to being light-transmissive at a wavelength of the optical signal emitted by the spin defect.

The dielectric light-transmissive element transmits the optical signal, e.g. in a direction orthogonal to a bonding surface of the diamond element, without guiding the optical signal by the dielectric light-transmissive element. Guiding an optical signal e.g. may refer to changing the direction of an optical signal. Guiding an optical signal refers to constraining the direction of an optical signal.

Coupling the optical signal by the dielectric light-transmissive element into the receiver element may refer to the optical signal transmitting through/passing through the dielectric light-transmissive element into the receiver element, e.g. without being guided by the dielectric light-transmissive element.

The dielectric light-transmissive element may guide the optical signal, e.g. in a direction parallel to a bonding surface of the diamond element. The dielectric light-transmissive element may be a dielectric waveguide. The dielectric light-transmissive element guiding light in a direction parallel to a bonding surface of the diamond element may be referred to as a dielectric lateral waveguide.

The dielectric light-transmissive element may be a crystal, e.g. a dielectric light-transmissive crystal element.

The receiver element may be located in a line of sight of the diamond element. The line of sight of the diamond element and the receiver element may traverse the tip portion, e.g. the coupling element. The line of sight may traverse the dielectric light-transmissive element. The receiver element does not need to be located in a line of sight of the diamond element.

The receiver element may be configured to receive the optical signal from the dielectric light-transmissive element.

The microwave antenna may be a microwave excitation line. The microwave antenna may be configured to generate a microwave near field. A microwave far field of the microwave antenna may be small and/or negligible as compared to the microwave near field.

The sensor device may comprise a plurality of tip portions, each comprising a respective coupling element and a respective diamond element bonded to the respective coupling element, each diamond element comprising at least one spin defect configured to emit an optical signal, each coupling element being formed of a material different from diamond and each coupling element being formed integrally with the dielectric light-transmissive element, and each coupling element being configured to couple the optical signal into the dielectric light-transmissive element. The sensor device may in addition also comprise one or more tip portions, e.g. comprising a respective coupling element and respective diamond element bonded thereto, that do not comprise at least one spin defect, e.g. due to a statistical distribution of spin defects across all tip portions during the manufacturing process.

Features disclosed with respect to the tip portion may be applicable to respective tip portions of the plurality of tip portions, as appropriate. The same applies for corresponding coupling elements, diamond elements and at least one spin defects of each tip portion.

The plurality of tip portions may form an array of tip portions. An array of such tip portions may e.g. allow to sample a surface area of a sample without scanning a tip portion across a sample surface, i.e. without moving a tip portion across a sample surface. An array of such tip portions may e.g. also be used for quantum computing/quantum information processing/NMR. An array of such tip portions may e.g. also be used in liquid or gas phases to detect liquids/gas phases and compositions thereof. Dielectric lateral waveguides may be comprised in a sensor device comprising an array of tip portions.

The dielectric light-transmissive element may be configured to couple the optical signal into the receiver element via free space. The dielectric light-transmissive element may be configured to couple the optical signal directly into the receiver element. E.g. in such a case, the receiver element does not need to be located in a line of sight of the diamond element. E.g. in such a case, the dielectric light-transmissive element may be a dielectric lateral waveguide.

The coupling element may be formed of the same material as the dielectric light-transmissive element. The coupling element and the dielectric light-transmissive element may be manufactured in a single microstructuring process.

The at least one spin defect may be a nitrogen vacancy (NV) center or a silicon vacancy (SV) center.

A crystal plane of the diamond element may be substantially parallel or substantially orthogonal to a bonding surface of the coupling element.

The bonding surface of the coupling element/the diamond element may be the respective surface at which the diamond element is bonded to the coupling element.

A crystal plane of the diamond element may be bonded to the coupling element. A crystal plane of the diamond element may be substantially parallel or substantially orthogonal to a crystal plane of the coupling element.

The above configurations may allow for high optical coupling efficiencies between the diamond element and the coupling element.

The diamond element and the coupling element may be flush. The bonding surface of the diamond element and the bonding surface of the coupling element may have the same size and the same shape. This may allow for high optical coupling efficiencies between the diamond element and the coupling element.

A cross-sectional area of the tip portion, in a plane orthogonal to a protruding direction of the tip portion, may increase in a direction from the top surface of the diamond element towards the dielectric light-transmissive element.

This may allow for high collection efficiencies of the dielectric light-transmissive element with respect to optical signals emitted by the spin defect, e.g. as light reflected at the surfaces of the tip portion then tends to be reflected towards the dielectric light-transmissive element.

A cross-sectional area of the diamond element and/or of the coupling element, in a plane orthogonal to a protruding direction of the tip portion, may increase in a direction from the top surface of the diamond element/of the coupling element towards the dielectric light-transmissive element.

The coupling element may have, in a cross section in a plane along a protruding direction of the tip portion, a tapered, a frustoconical or a trapezoidal shape. The diamond element may be bonded to the coupling element at a top surface of the coupling element. The diamond element and/or the tip portion may have, in a cross section in a plane along a protruding direction of the tip portion, a tapered, a multi-tapered, a parabolic, a hyperbolic or a trapezoidal shape.

The coupling element and/or the dielectric light-transmissive element may include an optical amplifier. The dielectric light-transmissive element may be a dielectric lateral waveguide.

The coupling element and/or the dielectric light-transmissive element may include one or more photonic integrated circuits. This may enable optical signal processing and may allow to obtain signals of higher quality at the receiver element.

An output of the receiver element may be coupled to an optical fiber/an optical waveguide.

An outer surface of the coupling element may be covered with a metal film, preferably with a metal film comprising silver. This may increase reflectance at the outer surface of the tip portion, decrease signal leakage at the outer surface of the tip portion, and hence increase the collection efficiency.

An outer surface of the dielectric light-transmissive element may be covered with a metal film, preferably with a metal film comprising silver. This may increase reflectance at the outer surface of the dielectric light-transmissive element, decrease signal leakage at the outer surface of the dielectric light-transmissive element, and hence increase the collection efficiency.

A lateral surface of the diamond element may be covered with a metal film, preferably with a metal film comprising silver. This may increase reflectance at the lateral surface of the diamond element, decrease signal leakage at the lateral surface of the diamond element, and hence increase the collection efficiency. The lateral surface may be an outer surface that is different from the bonding surface of the diamond element and different from the top surface of the diamond element. The top surface of the diamond element may be the outer surface of the diamond element that is opposite to the bonding surface of the diamond element.

The dielectric light-transmissive element and/or the coupling element may be formed of a glass material, sapphire, silicon oxide, silicon nitride, and/or gallium phosphide.

The diamond element may be bonded to the coupling element via fusion bonding or by using an intermediate layer or based on van der Waals interaction.

The diamond element and the coupling element may be directly bonded to each other. The intermediate layer may e.g. comprise a Hydrogen silsesquioxane (HSQ) and/or an oxide deposited by means of Atomic Layer Deposition.

A height of the diamond element may be 50µm or less, preferably 20µm or less, or 10 µm or less, or 5µm or less, or 2µm or less, or 1µm or less. A height of the diamond element may correspond to an integer multiple of a wavelength of the optical signal. The diamond element may have a cavity function with respect to light at a wavelength of the optical signal.

The height of the diamond element may be a height in a protruding direction of the tip portion, e.g. from a bonding surface of the diamond element towards a top surface of the diamond element opposite to the bonding surface.

A cavity function of the diamond element may be enabled by the height of the diamond element corresponding to an integer multiple of a wavelength of the optical signal.

The diamond element may have a quality factor of more than 1 at an emission wavelength of the spin defect/at a wavelength of the optical signal. The term cavity function may refer to the quality factor being more than 1.

The cavity function may enhance the optical signal emitted by the spin defect and hence e.g. improve the sensitivity of the sensor device.

The tip portion may have a height, e.g. from the dielectric light-transmissive element in the protruding direction, that may be below 500 µm, preferably below 200 µm, more preferably below 100 µm. An optical signal travelling from the spin defect towards the dielectric light-transmissive element may have an optical path inside the tip portion whose length may be below 500 µm, preferably below 200 µm, more preferably below 100 µm. This may allow for high collection efficiencies of the dielectric light-transmissive element with respect to optical signals of the spin defect.

A small height of the diamond element in the protruding direction may reduce the effect of aberrations in diamond, and may hence improve the quality of optical signals. The small height may improve the coupling efficiency between the diamond element and the dielectric light-transmissive element. The small height may also reduce the amount of background fluorescence of the diamond, which may have a detrimental effect on the optical signal of the spin defect, e.g. increasing noise on the optical signal.

The at least one spin defect may be located at a distance of 100 nm or less, preferably 50 nm or less, more preferably 10 nm or less from a surface of the diamond element, which may be the top surface, e.g. in the protruding direction when viewed from the dielectric light-transmissive element.

The resolution of the spin defect with respect to a magnetic field, e.g. on a sample surface, decreases as the distance between the spin defect and the sample surface increases. Hence, it is generally favorable to have a small distance between the spin defect and a top surface of the diamond element, in order to allow for a high resolution.

A refractive index of the dielectric light-transmissive element may be constant across the entire dielectric light-transmissive element. The surfaces of the dielectric light-transmissive element may be exposed to free space. The dielectric light-transmissive element may be a dielectric light-transmissive element without a cladding.

The dielectric light-transmissive element may consist of a single material. The dielectric light-transmissive element may have a homogeneous/single refractive index.

According to a second aspect of the present disclosure, a method for producing a sensor device is provided, the sensor device comprising a tip portion, a dielectric light-transmissive element, a receiver element, a microwave antenna and an excitation light source. The method comprises forming the tip portion comprising a coupling element and a diamond element, e.g. a single crystal diamond element, bonded to the coupling element. The diamond element comprises at least one spin defect configured to emit an optical signal. The coupling element configured to couple the optical signal into the dielectric light-transmissive element is formed of a material different from diamond and is formed integrally with the dielectric light-transmissive element. The dielectric light-transmissive element is configured to couple the optical signal into the receiver element. The coupling element protrudes from the dielectric light-transmissive element. The microwave antenna is configured to couple a microwave field to the spin defect. The excitation light source is configured to optically excite the spin defect by outputting excitation light.

The tip portion may be configured to be scanned over a sample surface. The coupling element may protrude from the dielectric light-transmissive element towards the sample surface.

Forming the tip portion may comprise bonding the diamond element to the dielectric light-transmissive element, and, e.g. subsequently, partially etching the dielectric light-transmissive element using an etching mask, such that the coupling element is formed having the diamond element bonded thereto. The diamond element may have been partially etched before bonding the diamond element to the dielectric light-transmissive element. The diamond element may be partially etched after bonding the diamond element to the dielectric light-transmissive element. Partially etching the dielectric light-transmissive element may also comprise partially etching the diamond element. Partially etching the dielectric light-transmissive element and partially etching the diamond element may be performed at the same time and/or during the same etching step. Partially etching the diamond element e.g. may be performed before partially etching the waveguide portion and e.g. may be performed after bonding the diamond element to the dielectric light-transmissive element. The diamond element may be partially etched using an etching mask, e.g. the same etching mask as used for partially etching the dielectric light-transmissive element. Forming the tip portion may comprise forming the coupling element by partially etching the dielectric light-transmissive element using an etching mask, and, e.g. subsequently, bonding the diamond element to the coupling element, such that the coupling element is formed having the diamond element bonded thereto.

According to a third aspect of the present disclosure, a use of the sensor device according to the first aspect of the present disclosure is provided. The use comprises: exciting, using excitation light output by the excitation light source, the spin defect, and receiving, by the receiver element, an optical signal emitted by the spin defect.

The optical signal may be a fluorescence signal, emitted e.g. upon excitation with the excitation light. The excitation light may have a shorter wavelength as compared to the wavelength of the optical signal.

### BRIEF DESCRIPTION OF THE DRAWINGS

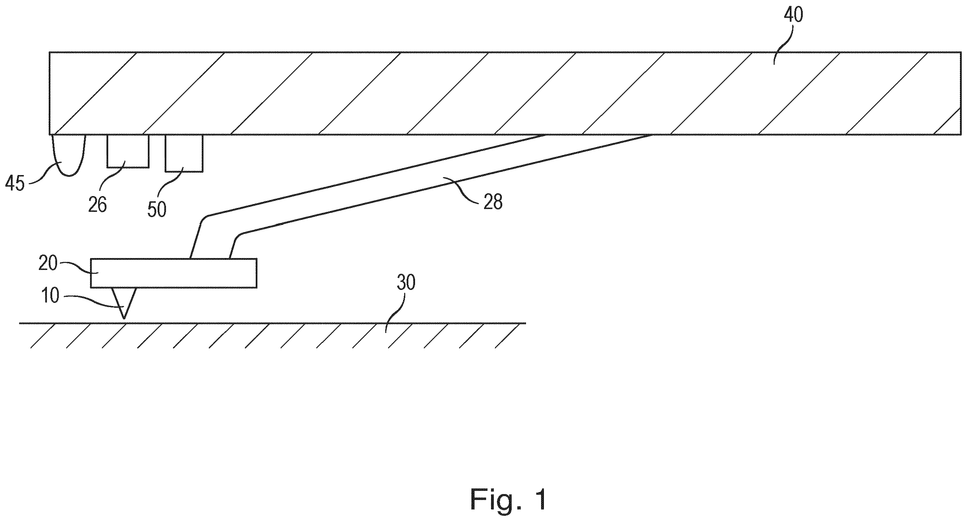

Reference will now be made to exemplary embodiments of the disclosure, examples of which are illustrated in the accompanying drawings. Wherever possible, the same reference numbers will be used throughout the drawings to refer to the same or like parts. Moreover, the features explained in context of a specific embodiment, for example that one of Fig. 1, also apply to any one of the other embodiments, when appropriate, unless differently described.
- Figure 1: is a highly schematic illustration of a sensor device according to embodiments of the present disclosure.
- Figures 2a and 2b: show different examples of tip portions according to embodiments of the present disclosure.
- Figure 3: shows an example of a tip portion according to embodiments of the present disclosure.
- Figures 4a and 4b: show different examples of tip portions according to embodiments of the present disclosure.
- Figure 5: is a top view of a tip portion and a dielectric light-transmissive element according to embodiments of the present disclosure.
- Figures 6a and 6b: show different examples of tip portions according to embodiments of the present disclosure.
- Figure 7: shows an example of a tip portion according to embodiments of the present disclosure.
- Figure 8: shows an example of a tip portion according to embodiments of the present disclosure.
- Figures 9a, 9b and 9c: show three views of an example of a tip portion according to embodiments of the present disclosure.
- Figure 10: shows an example of a method for forming a tip portion according to embodiments of the present disclosure.
- Figures 11a and 11b: show two examples of methods for forming a tip portion according to embodiments of the present disclosure.
- Figure 12: shows an example of a method for using a sensor device according to embodiments of the present disclosure.

### DESCRIPTION OF EMBODIMENTS

Figure 1 is a highly schematic illustration of a sensor device according to embodiments of the present disclosure. The sensor device comprises a tip portion 10, a dielectric light-transmissive element 20, and a receiver element 26. In the embodiment shown in Figure 1, the sensor device also includes a handle structure 28, a mounting system 40, a microwave antenna 45 and an excitation light source 50. Figure 1 also shows a sample 30. The sensor device may e.g. comprise a force feedback sensor (not shown in Fig. 1), e.g. a piezoelectric tuning fork sensor. The force feedback sensor e.g. may be used to feedback a tip-sample distance, i.e. to control a distance between the sample surface and the tip portion using a feedback loop.

The tip portion 10 comprises a coupling element 8 and a diamond element 6 (not explicitly shown in Fig. 1). The tip portion 10 protrudes from the dielectric light-transmissive element 20 in a protruding direction towards a surface of a sample 30. The tip portion 10 is configured to be scanned over the surface of the sample 30.

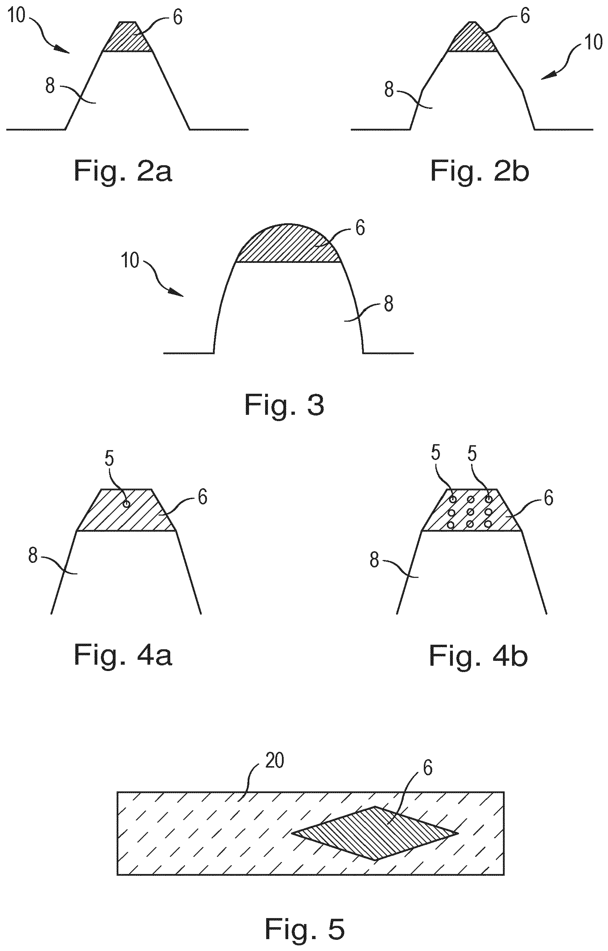

Figure 2a shows an example of a tip portion 10 including a coupling element 8 and a diamond element 6. The tip portion 10 and the diamond element 6 each have a tapered shape in a cross-section. The coupling element 8 has a trapezoidal shape. In the example illustrated in Figure 2b, the tip portion 10 and the diamond element 6 each have a multi-tapered shape.

Figure 3 illustrates an example of a tip portion 10, in which the tip portion 10 and the diamond element each have a parabolic shape or a hyperbolic shape.

The diamond element 6 is bonded to the coupling element 8. The diamond element 6 is located on top of the coupling element 8 in a direction from the dielectric light-transmissive element 20 to the tip portion 10, i.e. in a protruding direction of the tip portion 10 and of the coupling element 8. The diamond element 6 comprises at least one spin defect 5. The diamond element 6 may comprise a plurality of spin defects 5. The diamond element 6 may be a microsctructured diamond. The diamond element 6 may be a single crystal diamond.

The at least one spin defect 5 is configured to emit an optical signal. The optical signal may be a fluorescence signal, e.g. upon excitation with an optical excitation signal/excitation light having a shorter wavelength as compared to the wavelength of the optical signal emitted by the spin defect 5. The optical excitation signal/the excitation light may be output by the excitation light source 50.

The coupling element 8 is formed of a material different from diamond. The coupling element 8 is formed integrally with the dielectric light-transmissive element 20. The coupling element 8 is configured to couple the optical signal into the dielectric light-transmissive element 20. The coupling element 8 protrudes from the dielectric light-transmissive element 20 in a protruding direction towards a surface of the sample 30/towards the sample 30. The coupling element 8 may be configured to couple the optical signal directly into the dielectric light-transmissive element 20. The coupling element 8 may be formed of a crystal.

The dielectric light-transmissive element 20 is configured to couple the optical signal into the receiver element 26. The dielectric light-transmissive element 20 may comprise a lens and/or a solid immersion lens and/or a Fresnel lens and/or a meta material lens to enhance the coupling between the dielectric light-transmissive element 20 and the receiver element 26. The dielectric light-transmissive element 20 may be coupled to a lens and/or a solid immersion lens and/or a Fresnel lens and/or a meta material lens to enhance the coupling between the dielectric light-transmissive element 20 and the receiver element 26. The dielectric light-transmissive element 20 may comprise an antireflection coating, which may e.g. enhance the coupling.

The receiver element 26 is configured to receive the optical signal from the dielectric light-transmissive element 20, e.g. via free space. The receiver element 26 may comprise an image sensor, e.g. an avalanche photo diode and/or a CCD chip. The receiver element 26 may comprise an optical objective, e.g. a microscope objective.

The handle structure 28 mechanically connects the dielectric light-transmissive element 20 to the mounting system 40 that supports the handle structure 28. The handle structure 28 supports the dielectric light-transmissive element 20. The microwave antenna 45 is configured to couple a microwave field to the spin defect 5. The microwave antenna 45 may be mechanically coupled to the mounting system 40 (this configuration is shown in Fig. 1) or may be separate from the mounting system 40 (this configuration is not shown in Fig. 1). The excitation light source 50 is configured to optically excite the spin defect 5 by outputting excitation light.

The top surface of the coupling element may be the bonding surface of the coupling element. The top surface of the coupling element may be located opposite to the side of the coupling element at which the coupling element is connected to/integrally formed with the dielectric light-transmissive element.

The top surface of the coupling element may be a surface corresponding to the shorter side of the parallel sides of the trapezoid. The top surface of the coupling element may be a surface corresponding to the parallel surface of the frustum cone having the smaller surface area.

A bottom surface of the coupling element and/or a bottom surface of the tip portion may be connected to the dielectric light-transmissive element. The top surface of the coupling element may be a surface in the protruding direction, when viewed from the dielectric light-transmissive element.

A shape of the diamond element may be optimized for a high coupling efficiency of coupling the optical signal from the diamond element into the coupling element and/or into the dielectric light-transmissive element. A shape of the coupling element may be optimized for a high coupling efficiency of coupling the optical signal from the diamond element into the coupling element, and/or of coupling the optical signal from the coupling element into the dielectric waveguide. The above-mentioned shapes may enable favorable coupling efficiencies. The geometrical shapes of the diamond element and of the coupling element and/or of the dielectric waveguide may be jointly optimized for high coupling efficiency, i.e. they may be matched to each other.

This may allow for high collection efficiencies of the dielectric light-transmissive element with respect to optical signals emitted by the spin defect, e.g. as light reflected at the surfaces of the tip portion then tends to be reflected towards the dielectric light-transmissive element.

Figures 4a und 4b illustrate examples of tip portions 10, comprising a coupling element 8 and a diamond element 6. In the example of Figure 4a, the diamond element 6 includes a single spin defect 5. In the example of Figure 4b, the diamond element 6 includes a plurality of spin defects 5.

Figure 5 illustrates a top view of a tip portion 10 comprising a diamond element 6, and a dielectric light-transmissive element 20. Here, the dielectric light-transmissive element 20 is a dielectric lateral waveguide, guiding the optical signal in a lateral direction, i.e. in a direction orthogonal to a bonding surface of the diamond element 6. The sensor device may e.g. comprise a dielectric lateral waveguide as the dielectric light-transmissive element when the dielectric light-transmissive element and/or the coupling element comprises integrated photonics and/or is coupled to integrated photonics.

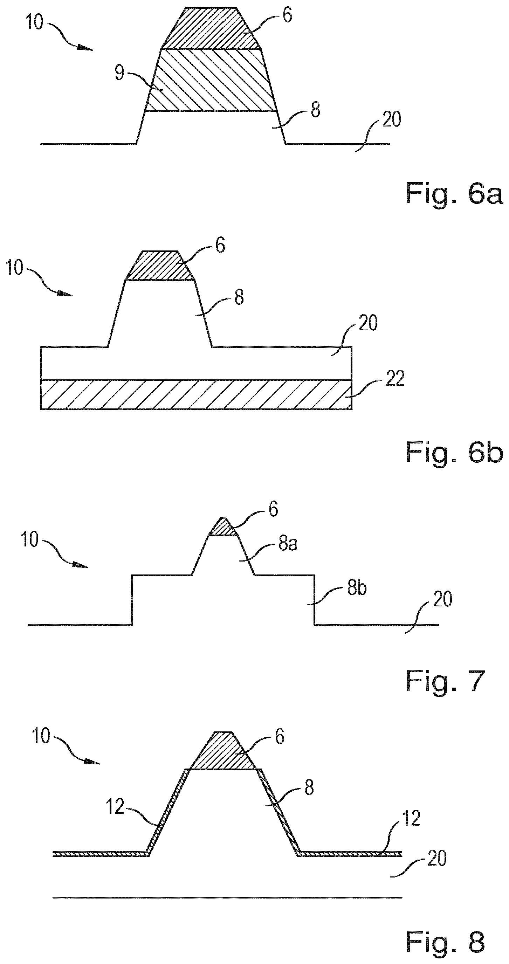

Figure 6a shows an example of a tip portion 10 comprising a diamond element 6 and a coupling element 8, wherein the coupling element 8 includes an optical amplifier 9. The coupling element 8 is formed integrally with the dielectric light-transmissive element 20.

Figure 6b shows an example of a tip portion 10 comprising a diamond element 6 and a coupling element 8. The coupling element 8 is formed integrally with the dielectric light-transmissive element 20. The dielectric light-transmissive element 20 includes an optical amplifier 22.

Figure 7 shows an example of a tip portion 10 comprising a diamond element 6 and a coupling element 8, which is formed integrally with a dielectric light-transmissive element 20. The coupling element 8 comprises a first section 8a and second section 8b. The first section 8a may be a diamond coupling section and may have a trapezoidal shape. The second section 8b may have a rectangular shape. The second section 8b may be a lateral waveguide section. The first section 8a may be omitted, e.g. when the diamond is shaped to match with the lateral waveguide section 8b.

Figure 8 shows an example of a tip portion 10 comprising a diamond element 6 and a coupling element 8. A surface of the coupling element 8 is covered with a metal film 12. A surface of the dielectric light-transmissive element 20 is covered with a metal film 12. The metal film 12 extends along a surface of the coupling element 8 and along a surface of the dielectric light-transmissive element 20.

A lateral surface of the diamond element 6 may be covered with a metal film.

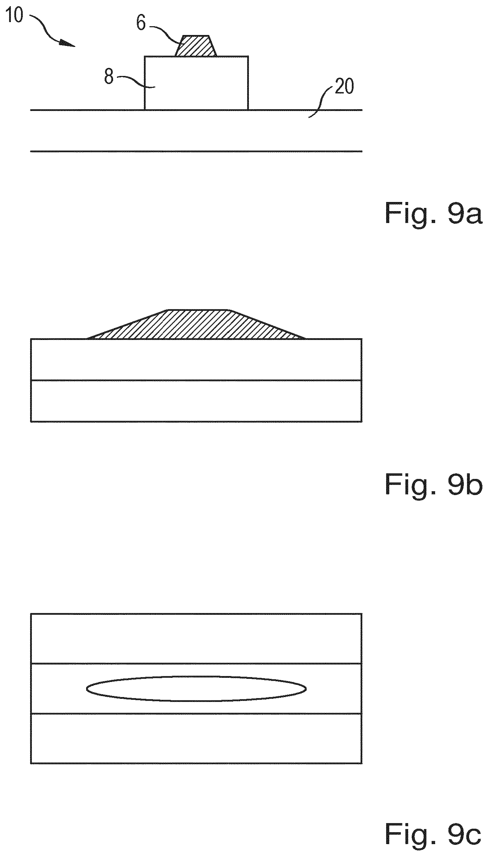

Figure 9 shows three views of an example of a tip portion 10 according to embodiments of the present disclosure. The tip portion 10 comprises a diamond element 6, a coupling element 8 and a dielectric light-transmissive element 20. Figures 9a shows a cross sectional view of the tip portion. Figure 9b shows a lateral view of the tip portion. Figure 9c shows a top view of the tip portion.

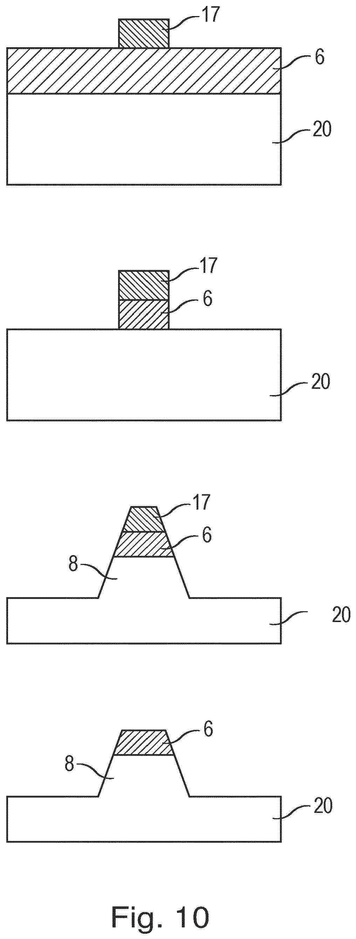

Figure 10 illustrates an example of a method for forming a tip portion 10 according to embodiments of the present disclosure. A dielectric light-transmissive element 20 is covered by a diamond element 6, and an etching mask 17 (first drawing). Parts of the diamond element 6 are etched (second drawing). Subsequently, the diamond element 6 and the dielectric light-transmissive element 20 are etched such that a shape of the diamond element 6 is modified, e.g. by modifying the shape of the diamond to be trapezoidal, and such that a portion of the dielectric light-transmissive element 20 protrudes from the waveguide. The shape of the diamond element 6 may be modified e.g. by changing the etching mask and/or by changing the etching chemistry to yield different erosion rates. The protruding portion of the dielectric light-transmissive element 20 is the coupling element 8 (third drawing). The etching mask 17 may be removed (fourth drawing).

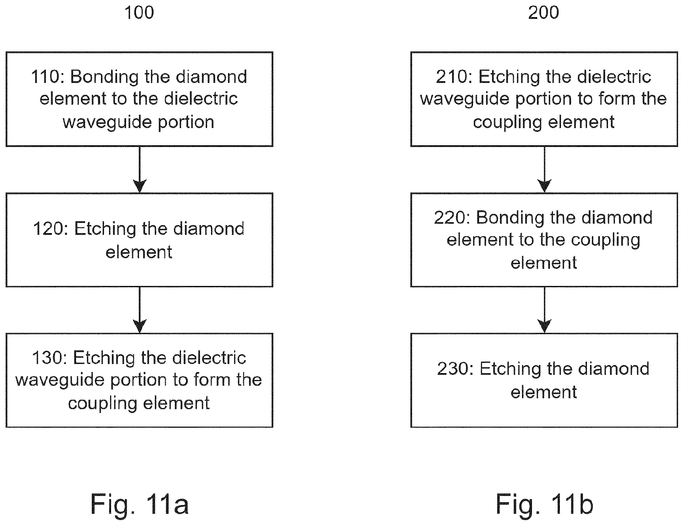

Figure 11a shows an example of a method 100 for forming a tip portion 10 according to embodiments of the present disclosure. In step 110, the diamond element 6 is bonded to a dielectric light-transmissive element 20. In optional step 120, the diamond element 6 is etched. In optional step 120, the shape of the diamond element 6 may be modified, e.g. optimized for optical coupling to the coupling element and to the dielectric light-transmissive element. In optional step 120, the thickness of the diamond element 6 may be reduced, i.e. the diamond element 6 may be thinned. In step 130, the dielectric light-transmissive element 20 is partially etched to form the coupling element 8 having the diamond element 6 bonded thereto. In step 130, the coupling element 8 may be etched such that its shape is modified, e.g. optimized for optical coupling to the dielectric light-transmissive element 20 and e.g. for receiving optical signals from the diamond element 6.

Figure 11a illustrates a similar method as the method illustrated in Figure 10. Features explained in the context of Figure 10 especially also apply in the context of Figure 11a, as appropriate, and vice versa.

Figure 11b shows an example of a method 200 for forming a tip portion 10 according to embodiments of the present disclosure. In step 210, the dielectric light-transmissive element 20 is partially etched to form the coupling element 8. In step 210, the coupling element 8 may be etched such that its shape is modified, e.g. optimized for optical coupling to the dielectric light-transmissive element and e.g. for receiving optical signals from the diamond element. In step 220, the diamond element 6 is bonded to the coupling element 8. In optional step 230, the diamond element 6 is etched. In optional step 230, the shape of the diamond element 6 may be modified, e.g. optimized for optical coupling to the coupling element 8 and to the dielectric light-transmissive element 20. In optional step 230, the shape of the diamond element 6 may be matched to the shape of the coupling element 8.

The diamond element 6 may be bonded to the dielectric light-transmissive element 20 first, and then, the dielectric light-transmissive element may be partially etched, such that the coupling element 8 is formed having the diamond element 6 bonded thereto. In other words: Forming the coupling element 8 by partially etching the dielectric light-transmissive element 20 may be performed after bonding the diamond element to the dielectric light-transmissive element.

The dielectric light-transmissive element may be partially etched first, such that the coupling element is formed, and then, the diamond element may be bonded to the coupling element subsequently, such that the coupling element is formed having the diamond element bonded thereto. In other words: Forming the coupling element by etching the dielectric light-transmissive element may be performed before bonding the diamond element to the coupling element.

The coupling element may be formed by partially etching the dielectric light-transmissive element using an etching mask. By partially etching the dielectric light-transmissive element using an etching mask, a portion of the dielectric waveguide that is covered by the etching mask and/or by the diamond element may become a protruding portion of the dielectric waveguide, and e.g. may become the coupling element.

The coupling element may be etched such that its shape is modified, e.g. optimized for optical coupling to the dielectric light-transmissive element and e.g. optimized for receiving optical signals from the diamond element.

Bonding the diamond element to the dielectric light-transmissive element and/or to the coupling element may comprise at least one of fusion bonding or bonding based on van der Waals interaction or bonding based on depositing an intermediate layer. The intermediate layer may e.g. comprise a Hydrogen silsesquioxane (HSQ), and/or an oxide deposited by means of Atomic Layer Deposition. Depositing the intermediate layer may comprise depositing the intermediate layer by means of Atomic Layer Deposition.

The method may comprise etching the diamond element bonded to the coupling element and/or to the dielectric light-transmissive element, e.g. such that a thickness of the diamond element is reduced and/or such that a shape of the diamond element is modified, e.g. optimized for optical coupling to the coupling element and/or the dielectric light-transmissive element. The method may comprise etching the diamond element along an implanted diamond. An aluminum mask or an aluminum oxide mask may be suitably used for etching the diamond element.

An aluminum mask may be suitably used for etching the waveguide and/or the coupling element.

The method may comprise, e.g. prior to bonding the diamond element to the dielectric light-transmissive element and/or to the coupling element, orienting/aligning the diamond element with respect to the dielectric light-transmissive element and/or the coupling element, e.g. vertically or horizontally. The diamond element may be oriented/aligned using the transparency of the diamond element.

Figure 12 shows an example of a method 300 for using a sensor device according to embodiments of the present disclosure. In step 310, a spin defect 5 is excited, using excitation light output by the excitation light source 50. In step 320, an optical signal, emitted by the spin defect 5, is received by the receiver element 26. Using the sensor device e.g. may allow to perform magnetic field sampling. Using the sensor device e.g. may allow to perform quantum information processing.

Although some aspects have been described in the context of a device, it is clear that these aspects also represent a description of the corresponding method, where a block or component corresponds to a method step or a feature of a method step. Analogously, aspects described in the context of a method step also represent a description of a corresponding component or item or feature of a corresponding device.

### LIST OF REFERENCE SIGNS

- 5: spin defect
- 6: diamond element
- 8: coupling element
- 9: optical amplifier
- 10: tip portion
- 12: metal film
- 17: etching mask
- 20: dielectric light-transmissive element
- 22: optical amplifier
- 26: receiver element
- 28: handle structure
- 40: mounting system
- 45: microwave antenna
- 50: excitation light source

## Claims

1. A sensor device comprising:
a tip portion (10) comprising a coupling element (8) and a diamond element (6) bonded to the coupling element (8),
a dielectric light-transmissive element (20), the tip portion (10) being fixed to the dielectric light-transmissive element (20)
a receiver element (26),
a microwave antenna (45), and
an excitation light source (50),
wherein the diamond element (6) comprises at least one spin defect (5) configured to emit an optical signal,
the coupling element (8) being formed of a material different from diamond and being formed integrally with the dielectric light-transmissive element (20), and being configured to couple the optical signal into the dielectric light-transmissive element (20),
the dielectric light-transmissive element (20) being configured to couple the optical signal into the receiver element (26),
wherein the coupling element (8) protrudes from the dielectric light-transmissive element (20),
wherein the microwave antenna (45) is configured to couple a microwave field to the spin defect (5),
wherein the excitation light source (50) is configured to optically excite the spin defect (5) by outputting excitation light,
the sensor device further comprising:
a mounting system (40) holding the receiver element (26), and
a handle structure (28) mechanically connecting the dielectric light-transmissive element (20) to the mounting system (40) such that the dielectric light-transmissive element (20) is positioned facing the receiver element (26) enabling transmission of optical signals from the dielectric light-transmissive element (20) to the receiver element (26).

2. Sensor device of claim 1, wherein the dielectric light-transmissive element (20) is configured to couple the optical signal into the receiver element (26) via free space.

3. Sensor device of one of claims 1 to 2, wherein the coupling element (8) is formed of the same material as the dielectric light-transmissive element (20), wherein the coupling element (8) and the dielectric light-transmissive element (20) are manufactured in a single microstructuring process.

4. Sensor device of one of claims 1 to 3, wherein the at least one spin defect (5) is a nitrogen-vacancy center, NV center, or a silicon-vacancy center, SV center.

5. Sensor device of one of claims 1 to 4, wherein a crystal plane of the diamond element (6) is substantially parallel or substantially orthogonal to a bonding surface of the coupling element (8).

6. Sensor device of one of claims 1 to 5, wherein a cross-sectional area of the tip portion (10), in a plane orthogonal to a protruding direction of the tip portion (10), increases in a direction from the top surface of the diamond element (6) towards the dielectric light-transmissive element (20).

7. Sensor device of one of claims 1 to 6,
wherein the coupling element (8) has, in a cross section in a plane along a protruding direction of the tip portion (10), a tapered, a frustoconical or a trapezoidal shape, and wherein the diamond element (6) is bonded to the coupling element (8) at a top surface of the coupling element (8), and/or
wherein the diamond element (6) and/or the tip portion (10) has, in a cross section in a plane along a protruding direction of the tip portion (10), a tapered, a multi-tapered, a parabolic, a hyperbolic or a trapezoidal shape.

8. Sensor device of one of claims 1 to 7, wherein the coupling element (8) and/or the dielectric light-transmissive element (20) includes an optical amplifier.

9. Sensor device of one of claims 1 to 8,
wherein an outer surface of the coupling element (8) is covered with a metal film (12), and/or
wherein a lateral surface of the diamond element (6) is covered with a metal film (12).

10. Sensor device of one of claims 1 to 9, wherein the dielectric light-transmissive element (20) and/or the coupling element (8) are formed of a glass material, sapphire, silicon oxide, silicon nitride, and/or gallium phosphide.

11. Sensor device of one of claims 1 to 10, wherein the diamond element (6) is bonded to the coupling element (8) via fusion bonding or by using an intermediate layer or based on van der Waals interaction.

12. Sensor device of one of claims 1 to 11,
wherein a height of the diamond element (6) is 50µm or less, preferably 20µm or less, and/or wherein a height of the diamond element (6) corresponds to an integer multiple of a wavelength of the optical signal and/or wherein the diamond element (6) has a cavity function with respect to light at a wavelength of the optical signal, and/or
wherein the at least one spin defect (5) is located at a distance of 100 nm or less, preferably 50 nm or less, more preferably 10 nm or less from a surface of the diamond element (6).

13. A method for producing a sensor device, comprising a tip portion (10), a dielectric light-transmissive element (20), wherein the tip portion (10) is fixed to the dielectric light-transmissive element (20), a receiver element (26), a microwave antenna (45), and an excitation light source (50),
the sensor device further comprising: a mounting system (40) holding the receiver element (26), and a handle structure (28) mechanically connecting the dielectric light-transmissive element (20) to the mounting system (40) such that the dielectric light-transmissive element (20) is positioned facing the receiver element (26) enabling transmission of optical signals from the dielectric light-transmissive element (20) to the receiver element (26), the method comprising:
forming the tip portion (10) comprising a coupling element (8) and a diamond element (6) bonded to the coupling element (8),
wherein the diamond element (6) comprises at least one spin defect (5) configured to emit an optical signal,
the coupling element (8) being formed of a material different from diamond and being formed integrally with the dielectric light-transmissive element (20), and being configured to couple the optical signal into the dielectric light-transmissive element (20),
the dielectric light-transmissive element (20) being configured to couple the optical signal into the receiver element (26),
wherein the coupling element (8) protrudes from the dielectric light-transmissive element (20),
wherein the microwave antenna (45) is configured to couple a microwave field to the spin defect (5),
wherein the excitation light source (50) is configured to optically excite the spin defect (5) by outputting excitation light.

14. The method of claim 13, wherein forming the tip portion comprises:
bonding the diamond element (6) to the dielectric light-transmissive element (20), and, subsequently, partially etching the dielectric light-transmissive element (20) using an etching mask (17), such that the coupling element (8) is formed having the diamond element (6) bonded thereto, or
forming the coupling element (8) by partially etching the dielectric light-transmissive element (20) using an etching mask (17), and, subsequently, bonding the diamond element (6) to the coupling element (8), such that the coupling element (8) is formed having the diamond element (6) bonded thereto.

15. Use of the sensor device according to any one of claims 1 to 12, comprising: exciting, using excitation light output by the excitation light source (50), the spin defect (5), and receiving, by the receiver element (26), an optical signal emitted by the spin defect (5).

## Patentansprüche

1. Eine Sensorvorrichtung, aufweisend:
einen Spitzenabschnitt (10), der ein Kupplungselement (8) und ein mit dem Kupplungselement (8) verbundenes Diamantelement (6) umfasst,
ein dielektrisches, lichtdurchlässiges Element (20), wobei der der Spitzenabschnitt (10) an dem dielektrischen, lichtdurchlässigen Element (20) befestigt ist
ein Empfangselement (26),
eine Mikrowellenantenne (45) und
eine Anregungslichtquelle (50),
wobei das Diamantelement (6) mindestens einen Spin-Defekt (5) umfasst, der so konfiguriert ist, dass er ein optisches Signal aussendet,
wobei das Kopplungselement (8) aus einem anderen Material als Diamant besteht und einstückig mit dem dielektrischen lichtdurchlässigen Element (20) ausgebildet ist und so konfiguriert ist, dass es das optische Signal in das dielektrische lichtdurchlässige Element (20) einkoppelt,
wobei das dielektrische lichtdurchlässige Element (20) so ausgebildet ist, dass es das optische Signal in das Empfangselement (26) einkoppelt,
wobei das Kopplungselement (8) aus dem dielektrischen lichtdurchlässigen Element (20) herausragt,
wobei die Mikrowellenantenne (45) so konfiguriert ist, dass sie ein Mikrowellenfeld an den Spin-Defekt (5) koppelt,
wobei die Anregungslichtquelle (50) so konfiguriert ist, dass sie den Spin-Defekt (5) durch Aussenden von Anregungslicht optisch anregt,
wobei die Sensorvorrichtung ferner umfasst:
ein Befestigungssystem (40), das das Empfangselement (26) hält, und
eine Haltestruktur (28), die das dielektrische lichtdurchlässige Element (20) mechanisch mit dem Befestigungssystem (40) verbindet, so dass das dielektrische lichtdurchlässige Element (20) dem Empfangselement (26) zugewandt positioniert ist, wodurch die Übertragung optischer Signale vom dielektrischen lichtdurchlässigen Element (20) zum Empfangselement (26) ermöglicht wird.

2. Sensorvorrichtung nach Anspruch 1, wobei das dielektrische lichtdurchlässige Element (20) so konfiguriert ist, dass es das optische Signal über den freien Raum in das Empfängerelement (26) einkoppelt.

3. Sensorvorrichtung nach einem der Ansprüche 1 bis 2, wobei das Kopplungselement (8) aus demselben Material wie das dielektrische lichtdurchlässige Element (20) gebildet ist, wobei das Kopplungselement (8) und das dielektrische lichtdurchlässige Element (20) in einem einzigen Mikrostrukturierungsprozess hergestellt wurden.

4. Sensorvorrichtung nach einem der Ansprüche 1 bis 3, wobei der mindestens eine Spin-Defekt (5) ein Stickstoff-Lücken-Zentrum (NV-Zentrum) oder ein Silizium-Lücken-Zentrum (SV-Zentrum) ist.

5. Sensorvorrichtung nach einem der Ansprüche 1 bis 4, wobei eine Kristallebene des Diamantelements (6) im Wesentlichen parallel oder im Wesentlichen orthogonal zu einer Bindungsfläche des Kopplungselements (8) ist.

6. Sensorvorrichtung nach einem der Ansprüche 1 bis 5, wobei sich die Querschnittsfläche des Spitzenabschnitts (10) in einer Ebene senkrecht zur Auskragungsrichtung des Spitzenabschnitts (10) in einer Richtung von der Oberseite des Diamantelements (6) hin zum dielektrischen lichtdurchlässigen Element (20) vergrößert.

7. Sensorvorrichtung nach einem der Ansprüche 1 bis 6,
wobei das Kopplungselement (8) in einem Querschnitt in einer Ebene entlang einer Auskragungsrichtung des Spitzenabschnitts (10) eine sich verjüngende, eine kegelstumpfförmige oder eine trapezförmige Gestalt aufweist, und wobei das Diamantelement (6) an einer Oberseite des Kopplungselements (8) mit dem Kopplungselement (8) verbunden ist, und/oder
wobei das Diamantelement (6) und/oder der Spitzenabschnitt (10) in einem Querschnitt in einer Ebene entlang einer Ausstreckungsrichtung des Spitzenabschnitts (10) eine konische, eine mehrfach konische, eine parabolische, eine hyperbolische oder eine trapezförmige Form aufweist.

8. Sensorvorrichtung nach einem der Ansprüche 1 bis 7, wobei das Kupplungselement (8) und/oder das dielektrische lichtdurchlässige Element (20) einen optischen Verstärker umfasst.

9. Sensorvorrichtung nach einem der Ansprüche 1 bis 8,
wobei eine Außenfläche des Kupplungselements (8) mit einer Metallschicht (12) bedeckt ist, und/oder
wobei eine Seitenfläche des Diamantelements (6) mit einer Metallschicht (12) bedeckt ist.

10. Sensorvorrichtung nach einem der Ansprüche 1 bis 9, wobei das dielektrische lichtdurchlässige Element (20) und/oder das Kopplungselement (8) aus einem Glasmaterial, Saphir, Siliziumoxid, Siliziumnitrid und/oder Galliumphosphid gebildet sind.

11. Sensorvorrichtung nach einem der Ansprüche 1 bis 10, wobei das Diamantelement (6) über Schmelzverbinden oder unter Verwendung einer Zwischenschicht oder auf der Grundlage von Van-der-Waals-Wechselwirkungen mit dem Kopplungselement (8) verbunden ist.

12. Sensorvorrichtung nach einem der Ansprüche 1 bis 11,
wobei die Höhe des Diamantelements (6) 50 µm oder weniger, vorzugsweise 20 µm oder weniger beträgt, und/oder wobei die Höhe des Diamantelements (6) einem ganzzahligen Vielfachen einer Wellenlänge des optischen Signals entspricht und/oder wobei das Diamantelement (6) eine Hohlraumfunktion in Bezug auf Licht bei einer Wellenlänge des optischen Signals aufweist, und/oder
wobei der mindestens eine Spin-Defekt (5) in einem Abstand von 100 nm oder weniger, vorzugsweise 50 nm oder weniger, noch bevorzugter 10 nm oder weniger von einer Oberfläche des Diamantelements (6) angeordnet ist.

13. Verfahren zur Herstellung einer Sensorvorrichtung, umfassend einen Spitzenabschnitt (10), ein dielektrisches lichtdurchlässiges Element (20), wobei der Spitzenabschnitt (10) an dem dielektrischen lichtdurchlässigen Element (20) befestigt ist, ein Empfangselement (26), eine Mikrowellenantenne (45) und eine Anregungslichtquelle (50),
wobei die Sensorvorrichtung ferner umfasst: ein Befestigungssystem (40), das das Empfangselement (26) hält, und eine Griffstruktur (28), die das dielektrische lichtdurchlässige Element (20) mechanisch mit dem Befestigungssystem (40) verbindet, so dass das dielektrische lichtdurchlässige Element (20) dem Empfangselement (26) zugewandt positioniert ist, wodurch die Übertragung optischer Signale vom dielektrischen lichtdurchlässigen Element (20) zum Empfangselement (26) ermöglicht wird, wobei das Verfahren umfasst:
Bilden des Spitzenabschnitts (10), der ein Kopplungselement (8) und ein mit dem Kopplungselement (8) verbundenes Diamantelement (6) umfasst,
wobei das Diamantelement (6) mindestens einen Spin-Defekt (5) umfasst, der so konfiguriert ist, dass er ein optisches Signal emittiert,
wobei das Kopplungselement (8) aus einem anderen Material als Diamant besteht und einstückig mit dem dielektrischen lichtdurchlässigen Element (20) ausgebildet ist und so konfiguriert ist, dass es das optische Signal in das dielektrische lichtdurchlässige Element (20) einkoppelt,
wobei das dielektrische lichtdurchlässige Element (20) so ausgebildet ist, dass es das optische Signal in das Empfängerelement (26) einkoppelt,
wobei das Kopplungselement (8) aus dem dielektrischen lichtdurchlässigen Element (20) herausragt,
wobei die Mikrowellenantenne (45) so konfiguriert ist, dass sie ein Mikrowellenfeld an den Spin-Defekt (5) koppelt,
wobei die Anregungslichtquelle (50) so konfiguriert ist, dass sie den Spin-Defekt (5) durch Aussenden von Anregungslicht optisch anregt.

14. Verfahren nach Anspruch 13, wobei das Ausbilden des Spitzenabschnitts umfasst:
das Verbinden des Diamantelements (6) mit dem dielektrischen lichtdurchlässigen Element (20) und anschließend das teilweise Ätzen des dielektrischen lichtdurchlässigen Elements (20) unter Verwendung einer Ätzmaske (17), so dass das Kopplungselement (8) gebildet wird, an das das Diamantelement (6) gebunden ist, oder
Bilden des Kopplungselements (8) durch teilweises Ätzen des dielektrischen lichtdurchlässigen Elements (20) unter Verwendung einer Ätzmaske (17) und anschließendes Verbinden des Diamantelements (6) mit dem Kopplungselement (8), so dass das Kopplungselement (8) mit dem daran verbundenen Diamantelement (6) gebildet wird.

15. Verwendung der Sensorvorrichtung gemäß einem der Ansprüche 1 bis 12, umfassend: Anregen des Spin-Defekts (5) unter Verwendung von von der Anregungslichtquelle (50) ausgegebenem Anregungslicht und Empfangen eines von dem Spin-Defekt (5) emittierten optischen Signals durch das Empfangselement (26).

## Revendications

1. Dispositif de détection comprenant :
une partie d'extrémité (10) comprenant un élément de couplage (8) et un élément en diamant (6) lié à l'élément de couplage (8),
un élément diélectrique transmettant la lumière (20), la partie d'extrémité (10) étant fixée à l'élément diélectrique transmettant la lumière (20),
un élément récepteur (26),
une antenne à micro-ondes (45), et
une source de lumière d'excitation (50),
où l'élément en diamant (6) comprend au moins un défaut de spin (5) conçu pour émettre un signal optique,
l'élément de couplage (8) étant formé en un matériau différent du diamant et formé d'un seul tenant avec l'élément diélectrique transmettant la lumière (20), et étant conçu pour coupler le signal optique à l'élément diélectrique transmettant la lumière (20),
l'élément diélectrique transmettant la lumière (20) étant configuré pour coupler le signal optique à l'élément récepteur (26),
où l'élément de couplage (8) fait saillie à partir de l'élément diélectrique transmettant la lumière (20),
où l'antenne à micro-ondes (45) est configurée pour coupler un champ de micro-ondes au défaut de spin (5),
où la source de lumière d'excitation (50) est configurée pour exciter optiquement le défaut de spin (5) en émettant une lumière d'excitation,
le dispositif de détection comprenant en outre :
un système de montage (40) supportant l'élément récepteur (26), et
une structure porteuse (28) reliant mécaniquement l'élément diélectrique transmettant la lumière (20) au système de montage (40) de telle sorte que l'élément diélectrique transmettant la lumière (20) est positionné face à l'élément récepteur (26), permettant ainsi la transmission de signaux optiques depuis l'élément diélectrique transmettant la lumière (20) vers l'élément récepteur (26).

2. Dispositif de détection de la revendication 1, où l'élément diélectrique transmettant la lumière (20) est configuré pour coupler le signal optique à l'élément récepteur (26) via un espace libre.

3. Dispositif de détection de l'une des revendications 1 à 2, où l'élément de couplage (8) est formé du même matériau que l'élément diélectrique transmettant la lumière (20), où l'élément de couplage (8) et l'élément diélectrique transmettant la lumière (20) sont fabriqués au cours d'un même processus de microstructuration.

4. Dispositif de détection de l'une des revendications 1 à 3, où l'au moins un défaut de spin (5) est un centre azote-lacune, centre NV, ou un centre silicium-lacune, centre SV.

5. Dispositif de détection de l'une des revendications 1 à 4, où un plan cristallin de l'élément en diamant (6) est sensiblement parallèle ou sensiblement orthogonal à une surface de liaison de l'élément de couplage (8).

6. Dispositif de détection de l'une des revendications 1 à 5, où une section transversale de la partie d'extrémité (10), dans un plan orthogonal à une direction de saillie de la partie d'extrémité (10), augmente dans une direction allant de la surface supérieure de l'élément en diamant (6) vers l'élément diélectrique transmettant la lumière (20).

7. Dispositif de détection de l'une des revendications 1 à 6,
où l'élément de couplage (8) présente, dans une section transversale dans un plan le long d'une direction de saillie de la partie d'extrémité (10), une forme conique, tronconique ou trapézoïdale, et où l'élément en diamant (6) est lié à l'élément de couplage (8) au niveau d'une surface supérieure de l'élément de couplage (8), et/ou
où l'élément en diamant (6) et/ou la partie d'extrémité (10) présente, dans une section transversale dans un plan le long d'une direction de saillie de la partie d'extrémité (10), une forme conique, à cônes multiples, parabolique, hyperbolique ou trapézoïdale.

8. Dispositif de détection de l'une des revendications 1 à 7, où l'élément de couplage (8) et/ou l'élément diélectrique transmettant la lumière (20) inclut un amplificateur optique.

9. Dispositif de détection de l'une des revendications 1 à 8,
où une surface extérieure de l'élément de couplage (8) est recouverte d'un film métallique (12), et/ou
où une surface latérale de l'élément en diamant (6) est recouverte d'un film métallique (12).

10. Dispositif de détection de l'une des revendications 1 à 9, où l'élément diélectrique transmettant la lumière (20) et/ou l'élément de couplage (8) sont constitués d'un matériau en verre, de saphir, d'oxyde de silicium, de nitrure de silicium et/ou de phosphure de gallium.

11. Dispositif de détection de l'une des revendications 1 à 10, où l'élément en diamant (6) est lié à l'élément de couplage (8) par liaison par fusion ou à l'aide d'une couche intermédiaire ou par interaction de van der Waals.

12. Dispositif de détection de l'une des revendications 1 à 11,
où une hauteur de l'élément en diamant (6) est de 50 µm ou moins, de préférence de 20 µm ou moins, et/ou où une hauteur de l'élément en diamant (6) correspond à un entier multiple d'une longueur d'onde du signal optique et/ou où l'élément en diamant (6) présente une fonction de cavité par rapport à la lumière à une longueur d'onde du signal optique, et/ou
où l'au moins un défaut de spin (5) est situé à une distance de 100 nm ou moins, de préférence de 50 nm ou moins, plus préférablement de 10 nm ou moins, d'une surface de l'élément en diamant (6).

13. Procédé de production d'un dispositif de détection, comprenant une partie d'extrémité (10), un élément diélectrique transmettant la lumière (20), où la partie d'extrémité (10) est fixée à l'élément diélectrique transmettant la lumière (20), un élément récepteur (26), une antenne à micro-ondes (45) et une source de lumière d'excitation (50),
le dispositif de détection comprenant en outre : un système de montage (40) supportant l'élément récepteur (26), et une structure porteuse (28) reliant mécaniquement l'élément diélectrique transmettant la lumière (20) au système de montage (40) de telle sorte que l'élément diélectrique transmettant la lumière (20) est positionné face à l'élément récepteur (26), permettant ainsi la transmission de signaux optiques depuis l'élément diélectrique transmettant la lumière (20) vers l'élément récepteur (26), le procédé comprenant :
la formation de la partie d'extrémité (10) comprenant un élément de couplage (8) et un élément en diamant (6) lié à l'élément de couplage (8),
où l'élément en diamant (6) comprend au moins un défaut de spin (5) configuré pour émettre un signal optique,
l'élément de couplage (8) étant formé en un matériau différent du diamant et étant formé d'un seul tenant avec l'élément diélectrique transmettant la lumière (20), et étant configuré pour coupler le signal optique à l'élément diélectrique transmettant la lumière (20),
l'élément diélectrique transmettant la lumière (20) étant configuré pour coupler le signal optique à l'élément récepteur (26),
où l'élément de couplage (8) fait saillie à partir de l'élément diélectrique transmettant la lumière (20),
où l'antenne à micro-ondes (45) est conçue pour coupler un champ de micro-ondes au défaut de spin (5),
où la source de lumière d'excitation (50) est conçue pour exciter optiquement le défaut de spin (5) en émettant une lumière d'excitation.

14. Procédé de la revendication 13, où la formation de la partie d'extrémité comprend :
la liaison de l'élément en diamant (6) à l'élément diélectrique transmettant la lumière (20), puis la gravure partielle de l'élément diélectrique transmettant la lumière (20) à l'aide d'un masque de gravure (17), de telle sorte que l'élément de couplage (8) est formé de telle sorte que l'élément en diamant (6) y est lié, ou
la formation de l'élément de couplage (8) par gravure partielle de l'élément diélectrique transmettant la lumière (20) à l'aide d'un masque de gravure (17), puis la liaison de l'élément en diamant (6) à l'élément de couplage (8), de telle sorte que l'élément de couplage (8) est formé de telle sorte que l'élément en diamant (6) y est lié.

15. Utilisation du dispositif de détection selon l'une quelconque des revendications 1 à 12, comprenant : l'excitation, à l'aide d'une lumière d'excitation émise par la source de lumière d'excitation (50), du défaut de spin (5), et la réception, par l'élément récepteur (26), d'un signal optique émis par le défaut de spin (5).
